# FASCICULE DE BREVET EUROPEEN

(11) **EP 2 608 644 B1**
(45) Date de publication et mention de la délivrance du brevet: **26.02.2020**
(21) Numéro de dépôt: 12197276.4
(22) Date de dépôt: 14.12.2012
(51) Int. Cl.: H05K 5/00, H04M 1/02

(54) **Portier électrique**
Elektrischer Türöffner
Electric gatekeeper

(30) Priorité: 21.12.2011 FR 1162139
(43) Date de publication de la demande: 26.06.2013
(73) Titulaire: Cogelec, 85290 Mortagne-sur-Sèvre (FR)
(72) Inventeur: Marchal, Norbert, 49130 Cholet (FR)
(74) Mandataire: Colombo, Michel

(56) Documents cités:
- FR-A1- 2 952 782

## Description

L'invention concerne un portier électrique. L'invention a également pour objet une étiquette et un porte-étiquettes pour ce portier électrique et un procédé de remplacement d'une étiquette de ce portier électrique.

Le portier électrique est un équipement, généralement situé à l'entrée d'une résidence, permettant d'appeler un combiné audiophonique d'un des résidents de cette résidence pour que celui-ci, en réponse, autorise ou interdise l'accès à la résidence. Typiquement, le portier électrique comporte donc aussi une unité de commande du déverrouillage et/ou du verrouillage d'au moins une porte d'accès à la résidence en fonction d'une commande transmise par le combiné du résident appelé.

Des portiers électriques connus comportent :
- au moins un bouton d'appel, chaque bouton déclenchant un appel vers un combiné audiophonique respectif d'un résident lorsqu'il est activé par un visiteur,
- au moins une étiquette remplaçable associée chacune à un bouton d'appel respectif, chaque étiquette comportant le nom du résident appelé lorsque le bouton d'appel associé est activé.

Plus précisément, ces portiers électriques connus comportent également :
- au moins une étiquette remplaçable, déplaçable entre une position insérée dans laquelle l'étiquette est fixée sur une face avant d'un porte-étiquettes, et une position retirée dans laquelle l'étiquette est mécaniquement indépendante du porte-étiquettes,
- le porte-étiquettes équipé de la face avant destinée à être exposée à l'extérieur de la résidence,
- au moins un épaulement sur l'un de l'étiquette et du porte-étiquettes, et
- au moins un bras de verrouillage sur l'autre de l'étiquette et du porte-étiquettes, déplaçable entre:
   - une position verrouillée dans laquelle le bras de verrouillage verrouille l'étiquette dans la position insérée par coopération de forme avec l'épaulement, et
   - une position déverrouillée dans laquelle l'étiquette peut être librement retirée du porte-étiquettes.

De tels portiers électriques sont décrits dans la demande de brevet FR 2952782.

Les portiers électriques connus fonctionnent correctement. Toutefois, il est souhaitable de les rendre encore plus robustes. En particulier, il est souhaitable de les rendre plus robustes vis-à-vis d'un choc frontal violent sur la face avant du porte-étiquettes, par exemple à l'aide d'une pierre. En effet, le déposant s'est aperçu qu'un tel choc pouvait provoquer l'éjection de l'étiquette du porte-étiquettes.

L'invention vise à remédier à cet inconvénient en proposant un portier électrique qui offre un procédé de remplacement des étiquettes simple, mais qui soit plus résistant aux chocs frontaux, en cas de vandalisme.

Elle a donc pour objet un portier électrique conforme à la revendication 1.

Le portier électrique ci-dessus résiste mieux aux chocs frontaux, car le bras de verrouillage ne peut pas se déplacer de sa position verrouillée vers sa position déverrouillée lorsqu'il est soumis à une force selon une direction perpendiculaire à la face avant du porte-étiquettes. En effet, son seul déplacement possible est parallèle à cette face avant. Ainsi, même un choc frontal violent n'aboutit pas à l'éjection de l'étiquette.

Les modes de réalisation de ce portier électrique peuvent comporter une ou plusieurs des caractéristiques des revendications dépendantes.

Ces modes de réalisation du portier électrique présentent en outre les avantages suivants :
- le bilame constitue un actionneur mécanique simple pour déclencher l'éjection de l'étiquette;
- la gâchette permet de rendre indépendant mécaniquement le bras de verrouillage du bilame, ce qui permet l'insertion d'une nouvelle étiquette sans attendre le retour du bilame à sa position initiale;
- le pan incliné sur l'épaulement de la broche de l'étiquette permet le déplacement de la gâchette de sa position active à sa position passive;
- le méplat formé par l'épaulement et le renfort sur lequel le bras de verrouillage prend appui permettent d'assurer une meilleure résistance à une force d'arrachement exercée sur l'étiquette;
- le déplacement en rotation seulement du bras de verrouillage autour d'un axe perpendiculaire à la face permet d'assurer une résistance aux chocs latéraux;
- l'écart qui existe entre l'épaisseur de l'extrémité du bras de verrouillage et celle du renfoncement de l'étiquette lorsque le bras est en position verrouillée, assure une meilleure résistance en cas de choc frontal en limitant l'impact du choc sur le bras de verrouillage;
- la lame ressort d'éjection facilite le retrait de l'étiquette lors d'une étape de remplacement de l'étiquette, avec un encombrement minimal en profondeur;
- la pointe à l'extrémité de la broche permet l'insertion de l'étiquette lorsque le bras de verrouillage est dans sa position verrouillée.

L'invention a également pour objet une étiquette pour le portier électrique ci-dessus.

L'invention a également pour objet un porte-étiquettes pour le portier électrique ci-dessus.

Enfin, l'invention a pour objet un procédé de remplacement d'une étiquette du portier électrique ci-dessus.

L'invention sera mieux comprise à la lecture de la description qui va suivre, donnée uniquement à titre d'exemple non limitatif et faite en se référant aux dessins sur lesquels :
- la figure 1 est une illustration schématique et en vue de côté d'un portier électrique,
- la figure 2 est une illustration schématique et partielle en vue de devant du portier électrique de la figure 1,
- la figure 3 est une illustration schématique et en vue de côté d'une étiquette du portier de la figure 1,
- la figure 4 est une illustration schématique et en perspective d'un porte-étiquettes du portier de la figure 1 lorsque l'étiquette de la figure 3 est en position insérée,
- la figure 5 est une illustration schématique et en coupe du porte-étiquettes de la figure 4,
- les figures 6, 7 et 8 sont des illustrations schématiques du portier dans différentes positions de fonctionnement,
- la figure 9 est un organigramme d'un procédé de remplacement d'une étiquette du portier électrique de la figure 1.

Dans ces figures, les mêmes références sont utilisées pour désigner les mêmes éléments.

Dans la suite de cette description, les caractéristiques et fonctions bien connues de l'homme du métier ne sont pas décrites en détails.

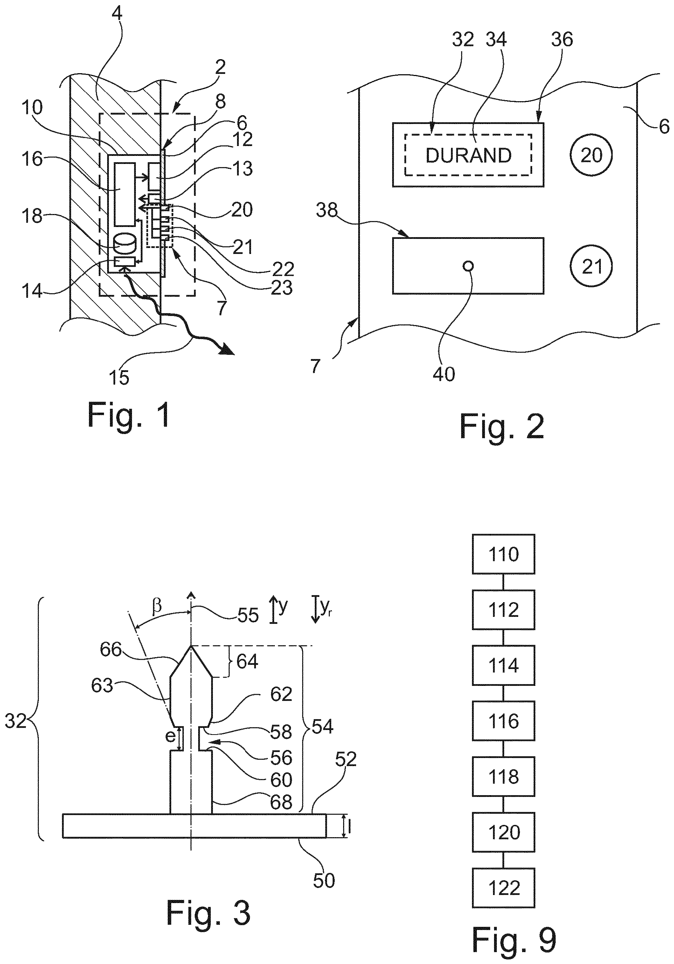

La figure 1 représente le portier 2 encastré dans un mur 4 d'une résidence. Le portier 2 fait partie d'un système de contrôle d'accès tel que celui décrit en référence à la figure 1 de la demande FR 2952782. Seule la face avant 6 de ce portier 2 est directement accessible depuis l'extérieur de la résidence. Le portier 2 comprend un porte-étiquettes 7. Ici, la face avant du porte-étiquettes 7 est confondue avec celle du portier 2. Par exemple, cette face avant 6 est constituée par la face avant d'une même platine antivandale 8. Une telle platine 8 est typiquement réalisée en métal de manière à résister aux différentes tentatives de vandalisme. Par exemple, cette platine est une plaque en inox de plus de 2 à 3 mm d'épaisseur ou une plaque en aluminium de plus de 3 à 4 mm d'épaisseur.

L'ensemble des composants électroniques du portier 2 est situé derrière cette platine 8 à l'intérieur d'une niche 10 creusée dans l'épaisseur du mur 4. Par exemple, un haut-parleur 12 et un microphone 13 sont situés dans la niche 10.

Le portier 2 comprend également, logés à l'intérieur de la niche 10:
- un émetteur-récepteur 14 permettant de raccorder le portier 2 à un réseau de transmission d'informations par l'intermédiaire d'une liaison 15 de transmission d'informations,
- une unité de commande 16 des différents équipements du portier 2, et
- une mémoire 18 raccordée à l'unité 16 de commande.

Typiquement, l'unité 16 est réalisée à partir de calculateurs électroniques programmables aptes à exécuter des instructions enregistrées sur un support d'enregistrement d'informations. A cet effet, les instructions nécessaires à l'exécution du procédé de la figure 9 sont enregistrées dans la mémoire 18.

L'accès à l'intérieur de la niche 10 n'est possible qu'en ouvrant le portier 2. L'ouverture du portier 2 consiste par exemple à déverrouiller, à l'aide d'un outillage spécial la platine 8 pour que l'accès à l'intérieur de la niche 10 soit rendu possible.

Le porte-étiquettes 7 comporte autant de boutons d'appel que de résidents. Ici, pour simplifier l'illustration, seuls quatre boutons d'appel 20 à 23 ont été représentés. Chaque bouton d'appel déclenche, lorsqu'il est activé, un appel vers le combiné d'un résident particulier. Par exemple, les boutons sont des boutons poussoirs qui sont activés lorsqu'un visiteur les enfonce.

La figure 2 représente plus en détail une partie de la face avant 6 du porte-étiquettes 7, confondue avec une partie de la face avant du portier 2. Les étiquettes identifiant les différents résidents sont fixées sur cette face avant 6.

Le porte-étiquettes 7 comprend une étiquette associée à chaque bouton d'appel 20 à 23. Sur chacune de ces étiquettes est marqué le nom du résident appelé lorsque le bouton associé est activé. Pour simplifier la figure, ici, seule l'étiquette 32 associée au bouton 20 est représentée.

De préférence, les étiquettes sont similaires les unes aux autres et seule l'étiquette 32 est maintenant décrite plus en détail.

L'étiquette 32 est directement exposée à l'extérieur sans être protégée par une fenêtre transparente. L'étiquette 32 comporte le nom 34 du résident appelé lorsque le bouton 20 qui lui est associé est activé. Ce nom est sculpté en relief ou en creux dans le matériau constituant l'étiquette. Ici, le nom 34 est gravé en creux dans la matière formant l'étiquette par un laser. Le nom est ainsi marqué de façon indélébile sur l'étiquette.

Pour résister aux tentatives de vandalisme, l'étiquette 32 est réalisée dans un matériau incassable et ininflammable.

Par incassable, on désigne un matériau indéformable dont l'indice de dureté de ROCKWELL HRB est supérieur à 50 et, de préférence, supérieur à 70. De préférence, ce matériau est au moins aussi dur qu'un acier inoxydable ou qu'un alliage d'aluminium. Par exemple, la dureté du matériau utilisé pour réaliser l'étiquette 32 peut être comparée à celle d'un autre métal en utilisant un indice de dureté de ROCKWELL HRC ou HRB.

Par ininflammable on désigne un matériau indestructible et indéformable lorsqu'il est chauffé à l'aide d'une flamme sur toute sa surface pendant cinq minutes. Typiquement, la température de la flamme est de 350° C.

Par exemple, l'étiquette 32 est réalisée en acier inoxydable dépoli ou en aluminium.

De manière à rendre l'arrachement de l'étiquette 32 plus difficile, celle-ci est reçue dans un logement borgne 36 creusé dans l'épaisseur de la platine 8. Ici, le porte-étiquettes 7 comprend un logement borgne par étiquette.

Les dimensions de l'étiquette 32 correspondent très précisément aux dimensions du logement 36.

Dans ce mode de réalisation, l'étiquette 32 comporte une broche non visible sur la figure 2, destinée à être insérée dans le logement 36 du porte-étiquettes 7. La broche est décrite plus en détail à la figure 3.

Sur la figure 2, un logement 38 dépourvu d'étiquette est également visible. Un canal de guidage 40 destiné à recevoir la broche de l'étiquette est creusé à travers la platine 8 et le porte-étiquettes 7. Ce canal 40 est complètement obturé par l'étiquette lorsque celle-ci est insérée dans le logement 38.

La figure 3 est une illustration en vue de côté d'une étiquette 32.

Dans ce mode de réalisation, l'étiquette 32 comporte au moins un épaulement et le porte-étiquettes 7 comporte au moins un bras de verrouillage.

L'étiquette 32 comporte une face avant 50 sur laquelle est inscrit le nom 34 d'un résident, et une face arrière 52 munie d'une broche 54. Ici, les faces 50 et 52 sont parallèles. La broche 54 est fixée sans aucun degré de liberté sur la face arrière 52, et s'étend perpendiculairement à la face 52.

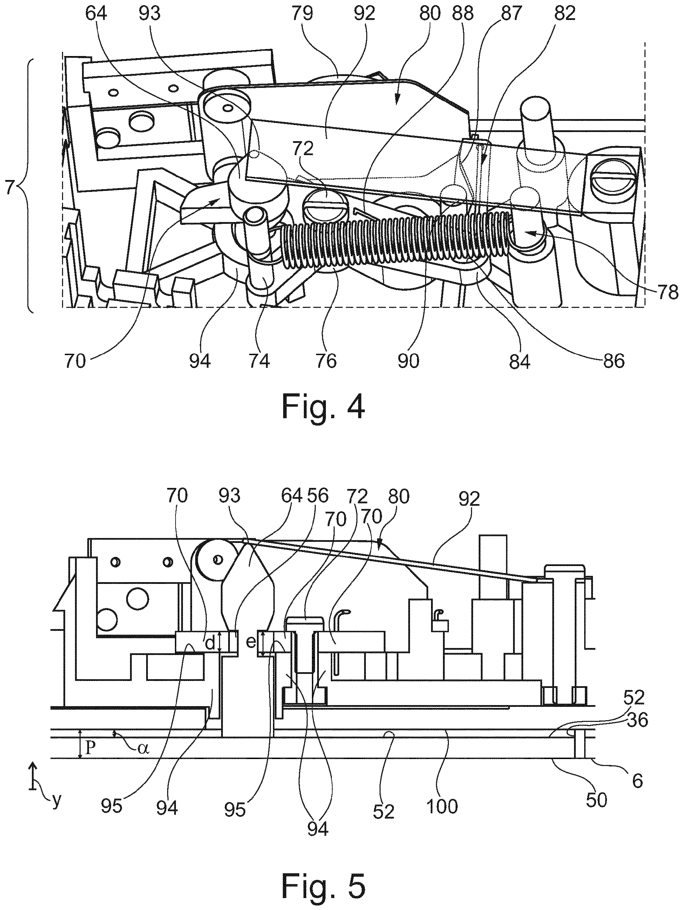

L'étiquette 32 a une épaisseur I, dans une direction perpendiculaire à la face 52, strictement inférieure à la profondeur P du logement 36 (visible sur la figure 5), mesurée dans la même direction lorsque l'étiquette 32 est insérée dans le logement 36. Ainsi, l'étiquette 32 ne crée aucune saillie au-delà de la face avant 6 ce qui la rend plus difficile à arracher.

La broche 54 a une forme cylindrique de section circulaire autour d'un axe 55 parallèle à une direction Y d'insertion. La direction Y est perpendiculaire à la face 52 et s'éloigne de cette face. Une direction de retrait, notée Yr, est parallèle et de sens opposé à la direction Y. La broche 54 est symétrique par rapport à l'axe 55. La broche 54 comporte, dans ce mode de réalisation, un renfoncement 56 délimité par:
- un premier épaulement 58, et
- un deuxième épaulement 60.

Dans ce mode de réalisation, les deux épaulements 58 et 60 sont deux méplats parallèles à la face avant 6 du porte-étiquettes 7, lorsque l'étiquette 32 est en position insérée. Le renfoncement 56 est creusé sur toute la circonférence de la broche 54. Il est destiné à recevoir une extrémité du bras de verrouillage du porte-étiquettes 7.

La largeur du renfoncement 56, dans la direction Y, mesurée entre les deux méplats 58 et 60 est notée e.

Le renfoncement 56 est suivi, selon la direction Y, d'un pan incliné 62.

Le pan incliné 62 définit avec la direction Y un angle β. Pour pouvoir repousser suffisamment le bras de verrouillage lorsque l'étiquette 32 est éjectée, l'angle β doit être compris entre 10 et 80°, et de préférence, entre 15 et 45°. Ici, par exemple, l'angle β a une valeur de 20°.

Le pan incliné 62 est suivi, selon l'axe Y, d'une partie cylindrique 63 de section circulaire.

La broche 54 présente une pointe 64 à son extrémité, constituée de flancs 66.

Dans la direction Yr à partir du renfoncement 56, la broche 54 se prolonge jusqu'à la face arrière 52 par un pied cylindrique 68 de même section ou de section supérieure à la section de la partie 63.

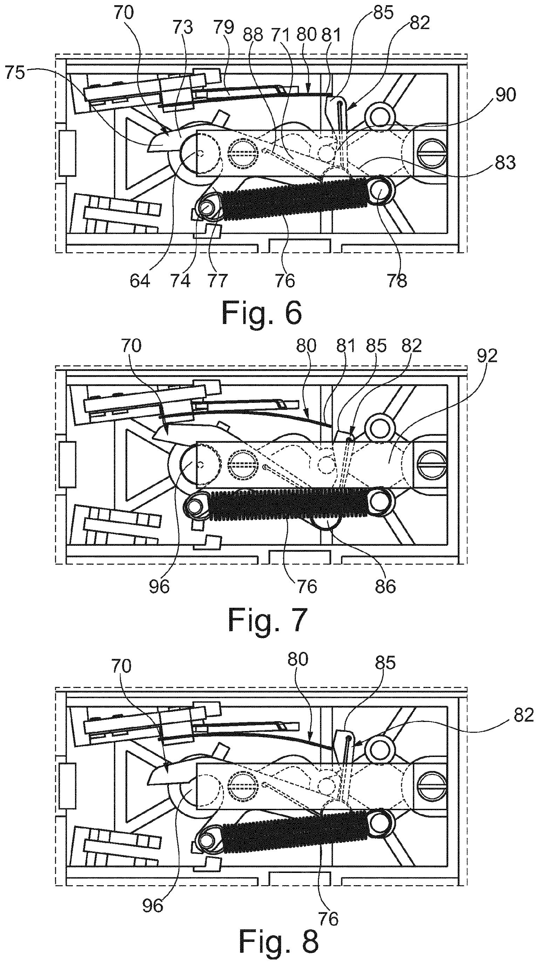

Le porte-étiquettes 7 va maintenant être décrit plus en détail en référence aux figures 4 à 8. Les figures 4 à 6 représentent le porte-étiquettes 7 lorsque l'étiquette 32 est en position insérée. Les figures 7 et 8 représentent le porte-étiquettes lorsque l'étiquette 32 commence à se déplacer de sa position insérée vers sa position retirée. Sur ces figures, le porte-étiquettes 7 s'étend essentiellement horizontalement dans un plan perpendiculaire à la direction d'insertion Y.

Dans la position insérée de l'étiquette 32, la pointe 64 de la broche 54 est située à l'intérieur de la niche 10 derrière la face avant 6.

Ici, le porte-étiquettes 7 comporte un bras de verrouillage 70 pour verrouiller la broche 54 de l'étiquette 32. Le bras 70 est déplaçable entre:
- une position verrouillée, représentée sur les figures 4 à 6 et 8, dans laquelle le bras 70 peut verrouiller l'étiquette 32 dans la position insérée par coopération de forme avec l'épaulement 58, et
- une position déverrouillée, représentée sur la figure 7, dans laquelle l'étiquette 32 peut être librement retirée du porte-étiquettes 7.

Le bras 70 se déplace entre ses positions verrouillée et déverrouillée uniquement dans un plan parallèle à la face avant 6 à ±20° près, et de préférence à ±10° près ou ± 5° près.

Ici, le bras 70 comprend une poutre 71 (figure 6) qui se termine par un crochet 73 qui comporte deux branches 75 et 77. La branche supérieure 75 est introduite dans le renfoncement 56 lorsque le bras 70 verrouille l'étiquette 32 dans sa position insérée. L'ouverture en partie encerclée par le crochet 73 est suffisamment large pour permettre le déplacement à coulissement dans la direction Y ou Yr de la partie cylindrique 63 à l'intérieur de cette ouverture.

Dans ce mode de réalisation, le bras 70 est uniquement mobile en rotation autour d'un axe 72 vertical (figure 4). L'axe 72 est situé à la jonction entre la partie du bras 70 formant le crochet 73 et celle formant la poutre 71.

Le crochet 73 comporte sur une extrémité, opposée à la poutre 71, de la branche inférieure 77 une tige 74 verticale. La tige 74 est fixée à une extrémité d'un moyen de rappel sollicitant en permanence le bras 70 vers sa position verrouillée. Ici, le moyen de rappel est un ressort hélicoïdal 76. L'extrémité opposée du ressort 76 est fixée sur une tige verticale 78 (figure 4) solidaire du porte-étiquettes 7.

Le porte-étiquettes 7 comporte également un bilame 80 et une gâchette 82.

Un bilame est une lame formée par l'assemblage d'au moins deux lames de métaux ou d'alliages différents. Les plus grandes faces de ces lames sont fixées sans aucun degré de liberté l'une contre l'autre. Ces lames ont des coefficients de dilatation différents. La dilatation de chacune des lames étant différente, le bilame se déforme en réponse à une variation de sa température. Ici, le bilame 80 se déforme entre une position rétractée, représentée sur les figures 4 à 6, et une position courbée, représentée sur les figures 7 et 8, en réponse à une augmentation de température. Cette augmentation de température est provoquée par une source commandable de chaleur telle qu'une résistance PTC (Positive Temperature Coefficient) 79. Une résistance PTC est une thermistance dont la résistance augmente avec la température. Ici, la résistance PTC permet d'atteindre une température comprise entre 100°C et 200°C. La résistance 79 est plaquée contre le bilame 80.

Ici, le bilame 80 est un bilame cloquant, c'est-à-dire que lors de son augmentation de température, le bilame 80 se déforme d'abord lentement puis atteint une certaine limite à partir de laquelle il se déforme très rapidement vers sa position courbée.

Le bilame 80 a pour fonction de déplacer le bras 70 de sa position verrouillée vers sa position déverrouillée en réponse à une augmentation de température.

Le bilame 80 s'étend dans un plan perpendiculaire à la face avant 6. Le bilame 80 est fixé sans aucun degré de liberté, par l'une de ses extrémités, au porte-étiquettes 7. L'autre extrémité 81 est laissée libre.

La gâchette 82 est déplaçable entre:
- une position active (représentée sur les figures 4 et 6) dans laquelle une extrémité inférieure 83 (figure 6) de la gâchette 82 est directement en contact mécanique avec une extrémité 84, opposée à celle se terminant par le crochet 73, de la poutre 71 et une extrémité supérieure 85 de la gâchette est directement en contact mécanique avec l'extrémité libre 81 du bilame 80 de manière à transformer un déplacement du bilame 80 en réponse à son augmentation de température en un déplacement du bras 70 de sa position verrouillée vers sa position déverrouillée, et
- une position passive (représentée sur les figures 7 et 8) dans laquelle l'extrémité supérieure 85 de la gâchette 82 est à côté de l'extrémité libre 81 pour isoler mécaniquement le bras 70 du bilame 80 de manière à ce que le bras 70 puisse se déplacer de sa position déverrouillée vers sa position verrouillée indépendamment de la position du bilame 80.

Dans la position passive, l'extrémité libre 81 du bilame 80 n'exerce pas de force sur la gâchette 82.

La gâchette 82 est articulée à son extrémité 83 au bras 70 sur un axe vertical 86 (figure 4). L'axe 86 est fixé sur l'extrémité 84 (figure 4) de la poutre 71. La gâchette 82 est mobile en rotation autour de cet axe 86, lui-même en rotation autour de l'axe 72 lorsque le bras 70 se déplace.

La gâchette 82 a ici la forme d'une languette. Le flanc de cette languette tourné vers l'axe 72 présente une face inclinée 87 (figure 4) d'appui sur un pion 90 vertical. Le pion 90 est fixé sans aucun degré de liberté au porte-étiquettes. L'inclinaison de cette face 87 est telle que lors du déplacement du bras 70 de sa position verrouillée vers sa position déverrouillée, le pion 90 frotte contre la face 87 pour déplacer la gâchette 82 de sa positon active vers sa position passive. Ici, le flanc tourné vers le bras 70 décrit une courbure telle que la largeur de la gâchette 82 est maximale en ses deux extrémités 83 et 85.

La gâchette 82 est associée à un moyen de rappel tel qu'un ressort 88 (figure 4). Le ressort 88 exerce une force de rappel de la gâchette 82 vers sa position active.

Le ressort 88 est composé de deux branches en "V". L'une d'elles est fixée le long de la poutre 71. L'autre branche du ressort 88 est fixée sur l'extrémité supérieure 85 de la gâchette. Le creux du "V" formé par les deux branches entoure l'axe 86.

Le pion 90 a pour fonction de limiter le déplacement de la gâchette 82 en exerçant une force de sens contraire à celle exercée par le ressort 88.

Le porte-étiquettes 7 comporte également une lame ressort d'éjection 92 rendue transparente sur la figure 4, afin de discerner les éléments du porte-étiquettes qui se trouvent entre la face avant 6 du porte-étiquettes et la lame 92. La lame 92 sollicite en permanence l'étiquette 32 dans la direction Yr lorsque celle-ci est en position insérée. Pour cela, une extrémité 93 de la lame 92 appuie sur la pointe 64 dans la direction Yr. L'extrémité opposée de la lame 92 est fixée sans aucun degré de liberté au porte-étiquettes 7.

Le porte-étiquettes 7 comporte un canal de guidage 96 (visible sur les figures 7 et 8), correspondant au canal 40 de la figure 2, destiné à recevoir la broche 54 de l'étiquette 32 lorsqu'elle est en position insérée. Le canal 96 a une section circulaire évidée et s'étend dans une direction verticale. Sa section est au moins égale à celle du pied 68 de la broche 54. Afin d'assurer une fonction de guidage, la longueur du canal 96, dans la direction verticale, est au moins égale à son diamètre, et de préférence supérieure à 1,5 fois son diamètre, ou encore 2 fois son diamètre.

Ce canal 96 est creusé dans un renfort 94 (figure 5) sur lequel le bras 70 prend appui lorsque:
- l'étiquette 32 est en position insérée,
- le bras de verrouillage 70 est en position verrouillée, et
- une force de traction est exercée pour déplacer l'étiquette 32 de sa position insérée vers sa position retirée.

Le renfort 94 a pour fonction d'améliorer la résistance du système de verrouillage en cas de tentative d'arrachement de l'étiquette 32. Pour assurer cette fonction, le renfort 94 est situé entre la face avant 6 du porte-étiquettes 7 et le bras 70. Il présente une face arrière 95 tournée vers le bras 70 et parallèle à la face avant 6. La face arrière 95 se trouve à proximité du canal de guidage 96. Par proximité, on entend ici une distance inférieure à 2 mm, et de préférence inférieure à 1 mm ou encore 0,5 mm. Lorsque le bras 70 est dans sa position verrouillée, le crochet 73 est séparé de la face 95 par un jeu inférieur à 1mm et, de préférence, inférieur à 0,5 ou 0,1 mm. Sur la figure 5, ce jeu n'a pas été représenté.

Le renfort 94 est constitué d'un matériau dur dont le module de Young est supérieur à 1 GPa, et de préférence supérieur à 30 GPa, ou encore 60 GPa. Par exemple, le renfort 94 est en plastique ou en métal.

Sur la figure 5, le logement 36 du porte-étiquettes 7 est visible. Le fond du logement 36 est référencé 100. La profondeur du logement 36, mesurée dans la direction Y, est notée P. La distance entre le fond 100 et la face arrière 52 de l'étiquette, mesurée dans la même direction, est notée α. Le crochet 73 a ici une épaisseur d (figure 5) mesurée dans la direction d'insertion Y. La distance α est reliée à la distance d et à la largeur e du renfoncement 56 par la relation suivante : α ≤ d-e.

Le fonctionnement du portier 2 va maintenant être décrit en regard du procédé de la figure 9.

Initialement, lors d'une étape 110, la nouvelle étiquette qui doit remplacer l'étiquette 32 est commandée.

Après avoir reçu la nouvelle étiquette, lors d'une étape 112, le portier 2 est basculé dans un mode de remplacement d'une étiquette. Différentes méthodes sont possibles pour basculer dans ce mode de remplacement. Par exemple, si un clavier est présent sur le portier 2, alors l'opérateur tape un code spécial qui bascule le portier 2 dans le mode de remplacement.

Si le portier 2 est équipé d'un lecteur de badge, alors un opérateur équipé d'un badge spécial passe celui-ci devant le lecteur. En réponse, le portier 2 bascule dans le mode de remplacement d'une étiquette.

Une fois que le portier 2 est en mode de remplacement d'une étiquette, celui-ci attend qu'on lui indique quelle est l'étiquette à remplacer. Dès lors, lors d'une étape 114, l'opérateur sélectionne l'étiquette à remplacer en appuyant sur le bouton d'appel associé à cette étiquette. On suppose ici que l'étiquette 32 est sélectionnée lors de cette étape 114.

Initialement, le porte-étiquettes est dans la position représentée sur la figure 6.

En réponse à la sélection de l'étiquette 32, lors d'une étape 116, l'unité 16 de commande génère une commande électrique qui est transmise à la résistance 79. La commande électrique est par exemple une impulsion de courant dont la durée est suffisante pour permettre l'augmentation en température du bilame 80.

En réponse à l'élévation de sa température, le bilame 80 se déforme de sa position rétractée à sa position courbée. L'extrémité libre 81 du bilame appuie alors sur l'extrémité 85, ce qui provoque un déplacement de la gâchette 82. Le déplacement de la gâchette 82 entraîne une rotation du bras 70 autour de l'axe 72, ce qui a pour effet de déplacer le bras 70 de sa position verrouillée vers une position intermédiaire où la branche 75 du crochet 73 est dégagée du méplat 58 et directement en contact mécanique avec le pan incliné 62. Sous l'effet de la poussée de la lame ressort 92, le pan incliné 62 repousse encore plus la branche 75 du crochet 73 de la position intermédiaire vers la position déverrouillée du bras 70. Dans la position déverrouillée, la partie cylindrique 63 coulisse dans la direction Yr à travers l'ouverture en partie encerclée par le crochet 73. Ainsi, l'étiquette 32 est éjectée du porte-étiquettes 7 et donc de son logement 36.

Lors de ce déplacement du bras 70, la gâchette 82 se déplace de sa position active (figure 6) vers sa position passive (figure 7). Plus précisément, sa face inclinée 87 glisse contre le pion 90 et son extrémité supérieure 85 s'éloigne alors de l'extrémité libre 81 du bilame. La gâchette 82 est alors dans sa position passive (figure 7).

Immédiatement après l'éjection de l'étiquette 32, lors d'une étape 118, le ressort 76 ramène le bras 70 de sa position déverrouillée vers sa position verrouillée (figure 8). Ceci est possible car, bien que le bilame 80 se trouve encore dans sa position courbée parce qu'il n'a pas encore refroidi, la gâchette 82 est dans sa position passive. Dans cette position, elle isole mécaniquement le bras 70 du bilame 80 car les extrémités 85 de la gâchette et 81 du bilame ne sont plus en contact. Le déplacement du bras 70 est donc possible. Le ressort 88 de gâchette sollicite en permanence la gâchette 82 vers sa position active. Le bilame 80 étant encore dans sa position courbée, son extrémité libre 81 se trouve alors à proximité de la face inclinée 87 de la gâchette (figure 8).

Ensuite, lors d'une étape 120, l'opérateur enlève l'étiquette éjectée 32 et enfonce dans le canal de guidage 96 la broche de la nouvelle étiquette à l'encontre de la sollicitation de la lame ressort 92. Lors de l'enfoncement de la broche 54, les flancs 66 de la pointe entrent en contact avec un bord de la branche 75 du crochet 73. Ce bord glisse alors le long du flanc 66 ce qui déplace le bras 70 de sa position verrouillée vers sa position déverrouillée. L'introduction d'une nouvelle étiquette est possible sans attendre le refroidissement du bilame 80 grâce à la gâchette 82 qui se trouve dans sa position passive (représentée sur la figure 8). En effet, dans le cas contraire, c'est-à-dire si la gâchette 82 était dans sa position active et le bilame 80 dans sa position courbée, le bras 70 ne pourrait pas se déplacer vers sa position verrouillée et la nouvelle étiquette serait donc aussitôt éjectée par la lame ressort 92.

Lors d'une étape 122, à la fin de la phase de refroidissement du bilame 80, le bilame 80 retrouve sa position rétractée. La gâchette 82 revient alors dans sa position active lorsque son extrémité 85 se glisse à nouveau sous l'extrémité 81 du bilame. Le porte-étiquettes 7 se retrouve dans une configuration identique à celle de la figure 6 et est prêt pour un nouveau remplacement d'étiquettes.

De nombreux autres modes de réalisation sont possibles.

Par exemple, le nom du résident peut être remplacé par un identifiant d'un appartement tel que son numéro.

Le nombre de logements borgnes prévus pour recevoir les étiquettes peut varier. Dans un cas extrême, un seul logement borgne est prévu pour recevoir l'ensemble des étiquettes. Dans ce cas, les étiquettes sont contiguës les unes aux autres pour empêcher l'insertion entre deux étiquettes d'une lame de couteau. L'interstice entre les étiquettes sera donc de préférence inférieur à 0,2 ou 0,3 mm.

L'étiquette peut être directement fixée sur le bouton d'appel.

En variante, le portier électrique ou le porte-étiquettes comprend un seul bouton d'appel associé à une seule étiquette.

Dans un autre mode de réalisation, les boutons 20 à 23 sont remplacés par un clavier permettant de sélectionner une étiquette.

Le moyen de rappel qu'exerce le ressort 76 peut également être obtenu en utilisant une ou plusieurs pièces aimantées. Par exemple, un ou plusieurs aimants sont utilisés pour attirer le bras 70 vers sa position de verrouillage.

De même, le ressort de gâchette 88 peut être différent de celui décrit ici.

Dans une variante présentée à titre illustratif et non revendiquée, l'épaulement 58 peut se trouver sur le porte-étiquettes et le bras de verrouillage sur l'étiquette. Par exemple, dans ce cas, la broche 54 est solidaire du porte-étiquettes. Le bilame peut aussi rester solidaire du porte-étiquettes et être conformé de manière à actionner le déplacement du bras de verrouillage qui se trouve à l'intérieur de l'étiquette.

Dans une variante illustrative, la broche 54 peut être omise. Par exemple, la face arrière de l'étiquette est délimitée par un rebord en saillie dans la direction Y. L'épaulement 58 et, de préférence, le pan incliné 62 sont alors réalisés dans ce rebord qui est introduit à l'intérieur du porte-étiquettes lors de l'insertion de l'étiquette.

La broche 54 peut aussi être réalisée différemment. Par exemple, sa section transversale peut être rectangulaire. L'épaulement 60 peut aussi être omis.

Le portier peut comporter des éléments supplémentaires tels qu'une caméra et un écran de manière à permettre l'établissement d'une vidéo conférence avec le résident appelé.

La face avant du porte-étiquettes 7 peut être, comme ici, confondue et formée d'un seul bloc avec la face avant du portier électrique. La face avant du porte-étiquettes peut également être réalisée dans un bloc de matière différent qui est ensuite ajusté dans un logement prévu à cet effet dans la face avant du portier électrique. Dans ce dernier cas, le porte-etiquettes peut être fabriqué indépendamment du portier électrique 2.

Le nombre de broches peut être supérieur ou égal à deux. De préférence, le même bras de verrouillage est conformé pour pouvoir déverrouiller simultanément les différentes broches.

En variante, le bilame est agencé pour provoquer le déverrouillage de l'étiquette en réponse à une diminution de sa température.

La forme initiale du bilame peut être une forme incurvée et non plate.

La forme du bras de verrouillage peut être différente de celle décrite ici. Par exemple, le crochet du bras comporte une seule branche. De même, la forme de la gâchette peut être différente.

En variante non revendiquée, le bras de verrouillage peut se déplacer en translation, et non plus en rotation, dans un plan parallèle à la face avant du porte-étiquettes.

Le porte-étiquettes décrit ici peut être utilisé dans d'autres appareils qu'un portier électrique. Par exemple, il peut être incorporé dans un panneau d'affichage juxtaposé à un ensemble de plusieurs boîtes aux lettres numérotées. Dans ce dernier cas, chaque étiquette porte, par exemple, le nom du résident et le numéro de sa boîte aux lettres.

## Revendications

1. Portier électrique (2) pour une résidence, ce portier électrique (2) comportant :
- une face avant (6) directement accessible depuis l'extérieure de la résidence,
- un porte-étiquettes (7) équipé d'une face avant (6) destinée à être exposée à l'extérieur de la résidence, la face avant du porte-étiquettes (7) étant :
- soit confondue et formée d'un seul bloc avec la face avant (6) du portier électrique,
- soit réalisée dans un bloc de matière différent de la face avant (6) qui est ajusté dans un logement prévu à cet effet dans la face avant (6) du portier électrique,
- au moins une étiquette (32) remplaçable, déplaçable entre une position insérée dans laquelle l'étiquette est fixée sur la face avant du porte-étiquettes (7), et une position retirée dans laquelle l'étiquette (32) est mécaniquement indépendante du porte-étiquettes (7), l'étiquette (32) comportant :
- une face avant (50) sur laquelle est inscrit un nom (34) d'un résident,
- une face arrière (52) munie d'au moins une broche (54), et
- au moins un épaulement (58) situé sur la broche (54) de l'étiquette (32), et
- dans lequel le porte-étiquettes comporte comporte au moins un bras de verrouillage (70) déplaçable entre:
• une position verrouillée dans laquelle le bras de verrouillage (70) verrouille l'étiquette (32) dans la position insérée par coopération de forme avec l'épaulement (58), et
• une position déverrouillée dans laquelle l'étiquette (32) peut être librement retirée du porte- étiquettes (7),
**caractérisé en ce que** :
- le bras de verrouillage (70) se déplace entre ses positions verrouillée et déverrouillée uniquement par un déplacement parallèle à la face avant (6) du porte-étiquettes et sans aucun déplacement dans une direction perpendiculaire à la face avant (6), et
- le bras de verrouillage (70) est uniquement mobile en rotation autour d'un axe (72) perpendiculaire à la face avant (6) du porte-étiquettes.

2. Portier (2) selon la revendication 1, dans lequel le portier comprend un bilame (80) propre à déplacer le bras de verrouillage (70) de sa position verrouillée vers sa position déverrouillée en réponse à une variation de sa température.

3. Portier (2) selon la revendication 2, dans lequel le portier comprend une gâchette (82) déplaçable entre:
- une position active dans laquelle la gâchette (82) relie mécaniquement le bras de verrouillage (70) au bilame (80) de manière à transformer un déplacement du bilame (80) en réponse à sa variation de température en un déplacement du bras de verrouillage (70) de sa position verrouillée vers sa position déverrouillée, et
- une position passive dans laquelle la gâchette (82) isole mécaniquement le bras de verrouillage (70) du bilame (80) de manière à ce que le bras de verrouillage (70) puisse se déplacer de sa position déverrouillée vers sa position verrouillée indépendamment de la position du bilame (80).

4. Portier (2) selon la revendication 3, dans lequel:
- la gâchette (82) est reliée mécaniquement au bras de verrouillage (70) par une articulation (86) permettant la rotation de l'un par rapport à l'autre dans un plan parallèle à la face avant (6) du porte-étiquettes lorsque l'étiquette (32) est en position insérée, et
- l'épaulement (58) comporte un pan incliné (62) apte à repousser suffisamment le bras de verrouillage (70) pour déplacer la gâchette (82) de sa position active à sa position passive, lorsque l'étiquette (32) se déplace de sa position insérée vers sa position retirée.

5. Portier (2) selon l'une quelconque des revendications précédentes, dans lequel:
- l'épaulement forme un méplat parallèle à la face avant (6) du porte-étiquettes lorsque l'étiquette (32) est dans sa position insérée,
- le porte-étiquettes (7) comporte un renfort (94), situé entre la face avant (6) du porte-étiquettes et le bras de verrouillage (70) et entre l'axe (72) de rotation du bras de verrouillage et une branche (75) du bras de verrouillage qui coopère avec l'épaulement (58) pour verrouiller l'étiquette dans sa position insérée, le bras de verrouillage (70) prenant appui sur ce renfort (94) au moins lorsque:
• l'étiquette (32) est en position insérée,
• le bras de verrouillage (70) est en position verrouillée, et
• une force de traction est exercée pour déplacer l'étiquette (32) de sa position insérée vers sa position retirée.

6. Portier (2) selon l'une quelconque des revendications précédentes, dans lequel :
- l'étiquette (32) comporte l'épaulement (58), dit premier épaulement, et un deuxième épaulement (60) définissant avec le premier épaulement un renfoncement (56) dans lequel vient se loger une extrémité (75) du bras de verrouillage (70) lorsqu'il est en position verrouillée, la largeur la plus courte de ce renfoncement dans une direction d'insertion de l'étiquette (32) de sa position retirée vers sa position insérée étant notée e,
- l'extrémité (75) du bras de verrouillage (70), selon la même direction d'insertion, présente une épaisseur d,
- l'étiquette (32) comporte une face arrière (52) espacée au maximum d'une distance α, mesurée selon la même direction d'insertion, de la face avant (6) du porte-étiquettes lorsque l'étiquette (32) est en position insérée et que le bras de verrouillage (70) est dans sa position verrouillée,
cette distance α étant inférieure ou égale à la distance e - d.

7. Portier (2) selon l'une quelconque des revendications précédentes, dans lequel le portier (2) comprend une lame ressort d'éjection (92) qui sollicite l'étiquette (32) vers l'extérieur du porte-étiquettes (7) lorsque l'étiquette (32) est en position insérée.

8. Portier (2) selon l'une quelconque des revendications précédentes, dans lequel:
- la broche (54) présente une pointe (64) à son extrémité,
- le bras de verrouillage (70) comporte une surface d'appui en contact avec l'un des flancs (66) de la pointe (64) de la broche pour repousser le bras de verrouillage (70) de sa position verrouillée vers sa position déverrouillée lors du déplacement de l'étiquette (32) de sa position retirée vers sa position insérée, et
- le porte-étiquettes (7) comporte au moins un canal de guidage (96) à l'intérieur duquel la broche (54) est enfoncée lors du déplacement de l'étiquette (32) de sa position retirée vers sa position insérée.

9. Portier (2) selon l'une quelconque des revendications précédentes, dans lequel la face avant du porte-étiquettes comporte un logement borgne (38) creusé dans son épaisseur, ce logement borgne étant apte à recevoir l'étiquette et comportant un canal de guidage (40) creusé à travers la face avant du porte-étiquettes, ce canal de guidage étant apte à recevoir la broche de l'étiquette et étant complètement obturé par l'étiquette lorsque celle-ci est insérée dans ce logement borgne.

10. Etiquette (32) pour un portier électrique (2) conforme à la revendication 1, cette étiquette (32) étant déplaçable entre une position insérée dans laquelle l'étiquette (32) est fixée sur une face avant (6) du porte-étiquettes, et une position retirée dans laquelle l'étiquette (32) est mécaniquement indépendante du porte-étiquettes (7), l'étiquette (32) comportant :
- une face avant (50) sur laquelle est inscrit un nom (34) d'un résident et une face arrière (52) munie d'au moins une broche (54), et
- l'épaulement (58) situé sur la broche (54) de l'étiquette (32),
**caractérisée en ce que** l'épaulement (58) comprend:
- un méplat, parallèle à la face avant (6) du porte-étiquettes lorsque l'étiquette (32) est dans sa position insérée, et
- un pan incliné (62) apte à repousser suffisamment le bras de verrouillage (70) pour déplacer la gâchette (82) de sa position active à sa position passive, lorsque l'étiquette (32) se déplace de sa position insérée vers sa position retirée.

11. Porte-étiquettes (7) apte à être ajusté dans un logement prévu à cet effet dans une face avant d'un portier électrique (2) conforme à l'une quelconque des revendications 1 à 9, comportant:
- la face avant destinée à être exposée à l'extérieur de la résidence et apte à être ajustée dans le logement prévu à cet effet dans la face avant (6) du portier électrique, cette face avant étant réalisée dans un bloc de matière différent de la face avant (6) du portier électrique,
- le bras de verrouillage (70) déplaçable entre:
• une position verrouillée dans laquelle le bras de verrouillage (70) verrouille l'étiquette (32) dans la position insérée par coopération de forme avec l'épaulement (58), et
• une position déverrouillée dans laquelle l'étiquette (32) peut être librement retirée du porte- étiquettes (7),
**caractérisé en ce que** :
- le bras de verrouillage (70) se déplace entre ses positions verrouillée et déverrouillée uniquement par un déplacement parallèle à la face avant (6) du porte-étiquettes et sans aucun déplacement dans une direction perpendiculaire à la face avant, et
- le bras de verrouillage (70) est uniquement mobile en rotation autour d'un axe (72) perpendiculaire à la face avant (6) du porte-étiquette.

12. Procédé de remplacement d'une étiquette (32) d'un portier (2) conforme à l'une quelconque des revendications 1 à 9, **caractérisé en ce que** le procédé comprend :
- la sélection de l'étiquette (32) à remplacer par activation d'un bouton d'appel (20) d'un combiné d'un résident associé à cette étiquette parmi plusieurs boutons d'appel (20, 21, 22, 23) associés chacun à une étiquette respective fixée sur le même portier électrique (2), et
- en réponse à cette sélection, le déplacement, uniquement parallèle à la face avant (6) du porte-étiquettes et sans aucun déplacement dans une direction perpendiculaire à la face avant, de la position verrouillée vers la position déverrouillée, du bras de verrouillage (70) verrouillant l'étiquette (32) sélectionnée dans sa position insérée.

## Patentansprüche

1. Elektrischer Türöffner (2) für ein Wohnhaus, wobei dieser elektrische Türöffner (2) umfasst:
- eine vordere Fläche (6), die direkt von der Außenseite des Wohnhauses zugänglich ist,
- einen Türschildträger (7), der mit einer vorderen Fläche (6) ausgestattet ist, die dazu bestimmt ist, zur Außenseite des Wohnhauses freizuliegen, wobei die vordere Fläche des Türschildträgers (7):
- entweder zu einem einzelnen Block mit der vorderen Fläche (6) des elektrischen Türöffners gebildet und geformt ist,
- oder aus einem Block aus einem anderen Material als die vordere Fläche (6) hergestellt ist, der in einer zu diesem Zweck bereitgestellten Aufnahme in der vorderen Fläche (6) des elektrischen Türöffners eingerichtet ist,
- mindestens ein austauschbares Türschild (32), das zwischen einer eingesetzten Position, in der das Türschild an der vorderen Fläche des Türschildträgers (7) befestigt ist, und einer herausgezogenen Position, in der das Türschild (32) mechanisch von dem Türschildträger (7) unabhängig ist, verschiebbar ist, wobei das Türschild (32) umfasst:
- eine vordere Fläche (50), auf die ein Name (34) eines Bewohners geschrieben ist,
- eine hintere Fläche (52), die mit mindestens einem Stift (54) versehen ist, und
- mindestens eine Schulter (58), die auf dem Stift (54) des Türschilds (32) angeordnet ist, und
- wobei der Türschildträger mindestens einen Verriegelungsarm (70) umfasst, der verschiebbar ist zwischen:
• einer verriegelten Position, in welcher der Verriegelungsarm (70) das Türschild (32) in der eingesetzten Position formschlüssig mit der Schulter (58) verriegelt, und
• einer entriegelten Position, in welcher das Türschild (32) frei aus dem Türschildträger (7) herausgezogen werden kann,
**dadurch gekennzeichnet, dass**:
- sich der Verriegelungsarm (70) zwischen seiner verriegelten und entriegelten Position nur durch eine Verschiebung parallel zu der vorderen Fläche (6) des Türschildträgers und ohne Verschiebung in einer Richtung rechtwinklig zu der vorderen Fläche (6) verschiebt, und
- der Verriegelungsarm (70) nur in Drehung um eine Achse (72) rechtwinklig zu der vorderen Fläche (6) des Türschildträgers bewegbar ist.

2. Türöffner (2) nach Anspruch 1,
wobei der Türöffner ein Bimetall (80) umfasst, das dafür geeignet ist, den Verriegelungsarm (70) aus seiner verriegelten Position in seine entriegelte Position ansprechend auf eine Variation seiner Temperatur zu verschieben.

3. Türöffner (2) nach Anspruch 2,
wobei der Türöffner eine Gate-Elektrode (82) umfasst, die verschiebbar ist zwischen:
- einer aktiven Position, in der die Gate-Elektrode (82) mechanisch den Verriegelungsarm (70) mit dem Bitmetall (80) verbindet, um eine Verschiebung des Bimetalls (80) ansprechend auf seine Temperaturvariation in eine Verschiebung des Verriegelungsarms (70) aus seiner verriegelten Position in seine entriegelte Position umzuwandeln, und
- einer passiven Position, in der die Gate-Elektrode (82) mechanisch den Verriegelungsarm (70) von dem Bimetall (80) isoliert, damit sich der Verriegelungsarm (70) aus seiner entriegelten Position in seine verriegelte Position unabhängig von der Position des Bimetalls (80) verschieben kann.

4. Türöffner (2) nach Anspruch 3, wobei:
- die Gate-Elektrode (82) mechanisch mit dem Verriegelungsarm (70) durch eine Gelenkverbindung (86) verbunden ist, die eine gegenseitige Drehung in einer Ebene parallel zu der vorderen Fläche (6) des Türschildträgers gestattet, wenn sich das Türschild (32) in der eingesetzten Position befindet, und
- die Schulter (58) eine geneigte Fläche (62) umfasst, die dafür geeignet ist, den Verriegelungsarm (70) ausreichend zurückzuschieben, um die Gate-Elektrode (82) aus ihrer aktiven Position in ihre passive Position zu verschieben, wenn sich das Türschild (32) aus seiner eingesetzten Position in seine herausgezogene Position verschiebt.

5. Türöffner (2) nach einem der vorhergehenden Ansprüche, wobei:
- die Schulter eine Abflachung parallel zu der vorderen Fläche (6) des Türschildträgers bildet, wenn sich das Türschild (32) in seiner eingesetzten Position befindet,
- der Türschildträger (7) eine Verstärkung (94) umfasst, welche zwischen der vorderen Fläche (6) des Türschildträgers und dem Verriegelungsarm (70) und zwischen der Drehachse (72) des Verriegelungsarms und einer Abzweigung (75) des Verriegelungsarms angeordnet ist, die mit der Schulter (58) zusammenwirkt, um das Türschild in seiner eingesetzten Position zu verriegeln, wobei der Verriegelungsarm (70) an dieser Verstärkung (94) anliegt, mindestens wenn:
- sich das Türschild (32) in der eingesetzten Position befindet,
- sich der Verriegelungsarm (70) in der verriegelten Position befindet, und
- eine Zugkraft ausgeübt wird, um das Türschild (32) aus einer eingesetzten Position in seine herausgezogene Position zu verschieben.

6. Türöffner (2) nach einem der vorhergehenden Ansprüche, wobei:
- das Türschild (32) die Schulter (58), die als erste Schulter bezeichnet wird, und eine zweite Schulter (60) umfasst, die mit der ersten Schulter eine Verstärkung (56) definiert, in der ein Ende (75) des Verriegelungsarms (70) aufgenommen ist, wenn er sich in der verriegelten Position befindet, wobei die kürzeste Breite dieser Verstärkung in einer Einsetzrichtung des Türschilds (32) von seiner herausgezogenen Position zu seiner eingesetzten Position mit e bezeichnet wird,
- das Ende (75) des Verriegelungsarms (70) in derselben Einsetzrichtung eine Dicke d aufweist,
- das Türschild (32) eine hintere Fläche (52) umfasst, die maximal in einer Distanz a, gemessen in derselben Einsetzrichtung, der vorderen Fläche (6) des Türschildträgers beabstandet ist, wenn sich das Türschild (32) in der eingesetzten Position befindet, und wenn sich der Verriegelungsarm (70) in seiner verriegelten Position befindet,
wobei diese Distanz α kleiner oder gleich der Distanz e - d ist.

7. Türöffner (2) nach einem der vorhergehenden Ansprüche,
wobei der Türöffner (2) eine Auswurfblattfeder (92) umfasst, die das Türschild (32) zur Außenseite des Türschildträgers (7) drückt, wenn sich das Türschild (32) in der eingesetzten Position befindet.

8. Türöffner (2) nach einem der vorhergehenden Ansprüche, wobei:
- der Stift (54) eine Spitze (64) an seinem Ende aufweist,
- der Verriegelungsarm (70) eine Anlagefläche in Kontakt mit einer der Flanken (66) der Spitze (64) des Stifts umfasst, um den Verriegelungsarm (70), bei der Verschiebung des Türschilds (32) aus seiner herausgezogenen Position in seine eingesetzte Position, aus seiner verriegelten Position in seine entriegelte Position zu schieben, und
- der Türschildträger (7) mindestens einen Führungskanal (96) umfasst, aus dessen Innerem der Stift (54) bei der Verschiebung des Türschilds (32) aus seiner herausgezogenen Position in seine eingesetzte Position herausgeführt wird.

9. Türöffner (2) nach einem der vorhergehenden Ansprüche,
wobei die vordere Fläche des Türschildträgers eine hohle Blindaufnahme (38) in ihrer Dicke umfasst, wobei diese Blindaufnahme dafür geeignet ist, um das Türschild aufzunehmen und einen hohlen Führungskanal (40) quer durch die vordere Fläche des Türschildträgers umfasst, wobei dieser Führungskanal dafür geeignet ist, den Stift des Türschilds aufzunehmen, und vollständig von dem Türschild verdeckt ist, wenn dieses in die Blindaufnahme eingesetzt ist.

10. Türschild (32) für einen elektrischen Türöffner (2) nach Anspruch 1, wobei dieses Türschild (32) zwischen einer eingesetzten Position, in der das Türschild (32) an einer vorderen Fläche (6) des Türschildträgers befestigt ist, und einer herausgezogenen Position, in der das Türschild (32) mechanisch von dem Türschildträger (7) unabhängig ist, verschiebbar ist, wobei das Türschild (32) umfasst:
- eine vordere Fläche (50), auf die ein Name (34) eines Bewohners geschrieben ist, und eine hintere Fläche (52), die mit mindestens einem Stift (54) versehen ist, und
- eine Schulter (58), die auf dem Stift (54) des Türschilds (32) angeordnet ist,
**dadurch gekennzeichnet, dass** die Schulter (58) umfasst:
- eine Abflachung parallel zu der vorderen Fläche (6) des Türschildträgers, wenn sich das Türschild (32) in seiner eingesetzten Position befindet, und
- eine geneigte Fläche (62), die dafür geeignet ist, den Verriegelungsarm (70) ausreichend zu schieben, um die Gate-Elektrode (82) aus ihrer aktiven Position in ihre passive Position zu verschieben, wenn sich das Türschild (32) aus seiner eingesetzten Position in seine herausgezogene Position verschiebt.

11. Türschildträger (7), welcher dafür geeignet ist, um in einer zu diesem Zweck bereitgestellten Aufnahme in der vorderen Fläche eines elektrischen Türöffners (2) nach einem der Ansprüche 1 bis 9 eingerichtet zu werden, umfassend:
- die vordere Fläche, die dazu bestimmt ist, zur Außenseite des Wohnhauses freizuliegen, und dafür geeignet ist, um in einer zu diesem Zweck bereitgestellten Aufnahme in der vorderen Fläche (6) des elektrischen Türöffners eingerichtet zu werden, wobei diese vordere Fläche in einem Block aus einem anderen Material als die vordere Fläche (6) des elektrischen Türöffners hergestellt ist,
- den Verriegelungsarm (70), der verschiebbar ist zwischen:
• einer verriegelten Position, in welcher der Verriegelungsarm (70) das Türschild (32) in der eingesetzten Position formschlüssig mit der Schulter (58) verriegelt, und
• einer entriegelten Position, in der das Türschild (32) frei aus dem Türschildträger (7) herausgezogen werden kann,
**dadurch gekennzeichnet, dass**:
- sich der Verriegelungsarm (70) zwischen seiner verriegelten und entriegelten Position nur durch eine Verschiebung parallel zu der vorderen Fläche (6) des Türschildträgers und ohne Verschiebung in einer Richtung rechtwinklig zu der vorderen Fläche verschiebt, und
- der Verriegelungsarm (70) nur in Drehung um eine Achse (72) rechtwinklig zu der vorderen Fläche (6) des Türschildträgers bewegbar ist.

12. Verfahren zum Austauschen eines Türschilds (32) eines Türöffners (2) nach einem der Ansprüche 1 bis 9, **dadurch gekennzeichnet, dass** das Verfahren umfasst:
- Auswählen des auszutauschenden Türschilds (32) durch Aktivierung eines Klingelknopfs (20) eines Hörers eines Bewohners, der diesem Türschild zugeordnet ist, unter mehreren Klingelknöpfen (20, 21, 22, 23), die jeweils einem jeweiligen Türschild zugeordnet sind, das an demselben elektrischen Türöffner (2) befestigt ist, und
- als Reaktion auf dieses Auswählen, Verschieben, nur parallel zu der vorderen Fläche (6) des Türschildträgers und ohne Verschiebung in einer Richtung rechtwinklig zu der vorderen Fläche, des Verriegelungsarms (70), der das ausgewählte Türschild (32) in seiner eingesetzten Position verriegelt, aus der verriegelten Position in die entriegelte Position.

## Claims

1. Electric gatekeeper (2) for a residence, this electric gatekeeper (2) comprising:
- a front face (6) that is directly accessible from the outside of the residence,
- a label-holder (7) equipped with a front face (6) intended to be exposed to the outside of the residence, the front face of the label-holder (7) being:
- either combined with and formed in a single block with the front face (6) of the electric gatekeeper,
- or produced in a block of different material from the front face (6) which is fitted into a recess provided for this purpose in the front face (6) of the electric gatekeeper,
- at least one replaceable label (32), that can be moved between an inserted position in which the label is fixed onto the front face of the label-holder (7), and a removed position in which the label (32) is mechanically independent of the label-holder (7), the label (32) comprising:
- a front face (50) on which is written a name (34) of a resident,
- a rear face (52) provided with at least one pin (54), and
- at least one shoulder (58) situated on the pin (54) of the label (32), and
- in which the label-holder comprises at least one locking arm (70) that can be moved between:
• a locked position in which the locking arm (70) locks the label (32) in the inserted position in a form-fitting manner with the shoulder (58), and
• an unlocked position in which the label (32) can be freely removed from the label-holder (7),
**characterized in that**:
- the locking arm (70) is moved between its locked and unlocked positions only by a movement parallel to the front face (6) of the label-holder and with no movement in a direction at right angles to the front face (6), and
- the locking arm (70) is only rotationally mobile about an axis (72) at right angles to the front face (6) of the label-holder.

2. Gatekeeper (2) according to Claim 1, wherein the gatekeeper comprises a bimetallic strip (80) designed to move the locking arm (70) from its locked position to its unlocked position in response to a variation of its temperature.

3. Gatekeeper (2) according to Claim 2, wherein the gatekeeper comprises a tumbler (82) that can be moved between:
- an active position in which the tumbler (82) mechanically links the locking arm (70) to the bimetallic strip (80) so as to convert a movement of the bimetallic strip (80) in response to its variation of temperature into a movement of the locking arm (70) from its locked position to its unlocked position, and
- a passive position in which the tumbler (82) mechanically isolates the locking arm (70) from the bimetallic strip (80) so that the locking arm (70) can be moved from its unlocked position to its locked position independently of the position of the bimetallic strip (80).

4. Gatekeeper (2) according to Claim 3, wherein:
- the tumbler (82) is linked mechanically to the locking arm (70) by an articulation (86) allowing the rotation of one relative to the other in a plane parallel to the front face (6) of the label-holder when the label (32) is in inserted position, and
- the shoulder (58) comprises an inclined facet (62) capable of pushing back the locking arm (70) sufficiently to move the tumbler (82) from its active position to its passive position, when the label (32) is moved from its inserted position to its removed position.

5. Gatekeeper (2) according to any one of the preceding claims, wherein:
- the shoulder forms a flat parallel to the front face (6) of the label-holder when the label (32) is in its inserted position,
- the label-holder (7) comprises a reinforcement (94), situated between the front face (6) of the label-holder and the locking arm (70) and between the axis (72) of rotation of the locking arm and a branch (75) of the locking arm which cooperates with the shoulder (58) to lock the label in its inserted position, the locking arm (70) bearing on this reinforcement (94) at least when:
• the label (32) is in inserted position,
• the locking arm (70) is in locked position, and
• a pulling force is exerted to move the label (32) from its inserted position to its removed position.

6. Gatekeeper (2) according to any one of the preceding claims, wherein:
- the label (32) comprises the shoulder (58), called first shoulder, and a second shoulder (60) defining, with the first shoulder, an indentation (56) in which an end (75) of the locking arm (70) comes to be housed when it is in locked position, the shortest width of this indentation in a direction of insertion of the label (32) from its removed position to its inserted position being denoted e,
- the end (75) of the locking arm (70), in the same direction of insertion, has a thickness d,
- the label (32) comprises a rear face (52) spaced apart at most by a distance α, measured in the same direction of insertion, from the front face (6) of the label-holder when the label (32) is in inserted position and the locking arm (70) is in its locked position,
this distance α being less than or equal to the distance e - d.

7. Gatekeeper (2) according to any one of the preceding claims, wherein the gatekeeper (2) comprises an ejection spring blade (92) which stresses the label (32) towards the outside of the label-holder (7) when the label (32) is in inserted position.

8. Gatekeeper (2) according to any one of the preceding claims, wherein:
- the pin (54) has a point (64) at its end,
- the locking arm (70) comprises a bearing surface in contact with one of the flanks (66) of the point (64) of the pin to push back the locking arm (70) from its locked position to its unlocked position upon the movement of the label (32) from its removed position to its inserted position, and
- the label-holder (7) comprises at least one guiding channel (96) within which the pin (54) is fitted upon the movement of the label (32) from its removed position to its inserted position.

9. Gatekeeper (2) according to any one of the preceding claims, wherein the front face of the label-holder comprises a blind recess (38) hollowed out in its thickness, this blind recess being capable of receiving the label and comprising a guiding channel (40) hollowed out through the front face of the label-holder, this guiding channel being capable of receiving the pin of the label and being completely concealed by the label when the latter is inserted into this blind recess.

10. Label (32) for an electric gatekeeper (2) according to Claim 1, this label (32) being able to be moved between an inserted position in which the label (32) is fixed onto a front face (6) of the label-holder, and a removed position in which the label (32) is mechanically independent of the label-holder (7), the label (32) comprising:
- a front face (50) on which is written a name (34) of a resident and a rear face (52) provided with at least one pin (54), and
- the shoulder (58) situated on the pin (54) of the label (32),
**characterized in that** the shoulder (58) comprises:
- a flat, parallel to the front face (6) of the label-holder when the label (32) is in its inserted position, and
- an inclined facet (62) capable of pushing back the locking arm (70) sufficiently to move the tumbler (82) from its active position to its passive position, when the label (32) is moved from its inserted position to its removed position.

11. Label-holder (7) capable of being fitted in a recess provided for this purpose in a front face of an electric gatekeeper (2) according to any one of Claims 1 to 9, comprising:
- the front face intended to be exposed to the outside of the residence and capable of being fitted in the recess provided for this purpose in the front face (6) of the electric gatekeeper,
this front face being produced in a block of material different from the front face (6) of the electric gatekeeper,
- the locking arm (70) that can be moved between:
• a locked position in which the locking arm (70) locks the label (32) in its inserted position in a form-fitting manner with the shoulder (58), and
• an unlocked position in which the label (32) can be freely removed from the label-holder (7),
**characterized in that**:
- the locking arm (70) is moved between its locked and unlocked positions only by a movement parallel to the front face (6) of the label-holder and with no movement in a direction at right angles to the front face, and
- the locking arm (70) is only rotationally mobile about an axis (72) at right angles to the front face (6) of the label-holder.

12. Method for replacing a label (32) of a gatekeeper (2) according to any one of Claims 1 to 9, **characterized in that** the method comprises:
- the selection of the label (32) to be replaced by activation of a call button (20) of a handset of a resident associated with this label out of several call buttons (20, 21, 22, 23) each associated with a respective label fixed onto the same electric gatekeeper (2), and
- in response to this selection, the movement, only parallel to the front face (6) of the label-holder and with no movement in a direction at right angles to the front face, from the locked position to the unlocked position, of the locking arm (70) locking the selected label (32) in its inserted position.
